# EUROPEAN PATENT APPLICATION

(11) **EP 1 652 871 A1**
(43) Date of publication of application: **03.05.2006**
(21) Application number: 05256685.8
(22) Date of filing: 27.10.2005
(51) Int. Cl.: C08G 77/38

(54) **Silicone encapsulants for light emitting diodes**

(30) Priority: 27.10.2004 US 622653 P
(71) Applicant: RENSSELAER POLYTECHNIC INSTITUTE, Troy New York 12180 (US)
(72) Inventor: Crivello, James V., Clifton Park, New York 12065 (US)
(74) Representative: Wallace, Sheila Jane

(57) **Abstract**

Silicone-based polymers and polymeric compositions, methods of preparation of the silicone-based polymers and polymeric compositions, and methods of use thereof with light emitting diodes (LED) are presented.

## Description

The following invention was made with Government support under contract number DE-FC26-01NT41203 awarded by the United States Department of Energy. The Government has certain rights.

### CROSS-REFERENCE TO RELATED APPLICATIONS

This application claims priority from U.S. Provisional Application Serial Number 60/622,653, filed October 27, 2004, the entire contents of which are incorporated herein by reference.

### FIELD OF THE INVENTION

The invention relates to silicone-based polymers and polymeric compositions, methods of preparation of the silicone-based polymers and polymeric compositions, and methods of use thereof with light emitting diodes (LED).

### BACKGROUND OF THE INVENTION

The next generation of high intensity light emitting diodes (LED) that are being developed for industrial and residential lighting applications will require a new class of encapsulants. There are no viable encapsulant alternatives existing that can meet the long term (10,000 hrs - 100,000 hrs) and high temperature (100°C - 200° C) operating conditions.

Currently available epoxy encapsulants as well as other polymeric encapsulants undergo unacceptable yellowing and degradation under the strenuous operating conditions employed for high intensity LEDs. Further, any new candidate encapsulant must be manufactured under conditions similar to and compatible with current encapsulant production methodologies. A need exists for polymers and polymer films, and methods of use thereof with LEDs that overcome at least one of the aforementioned deficiencies.

### SUMMARY OF THE INVENTION

An aspect of the present invention relates to a polymer produced by the process of reacting:
1. a cyclosiloxane oligomer of the formula X: 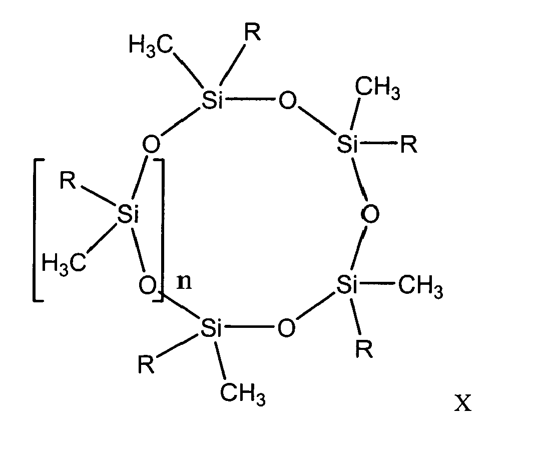 with
2. a vinyl siloxane oligomer of formula XI 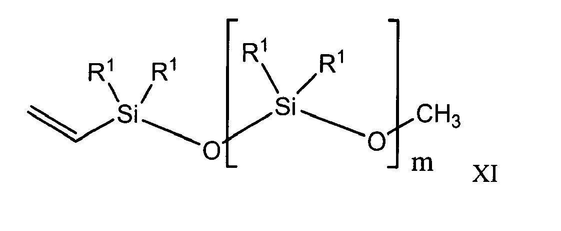 in the presence of a noble metal hydrosilation catalyst. In oligomer X, n is an integer from 0 to 6. R in each occurrence can be chosen independently from H, a methyl, an alkyl, and a haloalkyl, with the proviso that at least two of R must be H. In oligomer XI, m is an integer from 2 to 20. R¹ in each occurrence can be chosen independently for each siloxane unit from CH₃, OCH₃, OCH₂CH₃, vinyl, and a further unit of [-O-SiR¹₂-]q-OCH₃, wherein q is an integer from 2 to 20. At least one of R¹ must be a vinyl-containing unit. The vinyl siloxane oligomer must have a viscosity from10 centipoise to 10,000 centipoise at 25° C and the ratio of alkoxy groups to Si atoms is in a range from 0.004:1 to 1.5:1.

A second aspect of the present invention relates to a polymeric composition produced by the process of reacting:
a. a cyclosiloxane oligomer of the formula X: 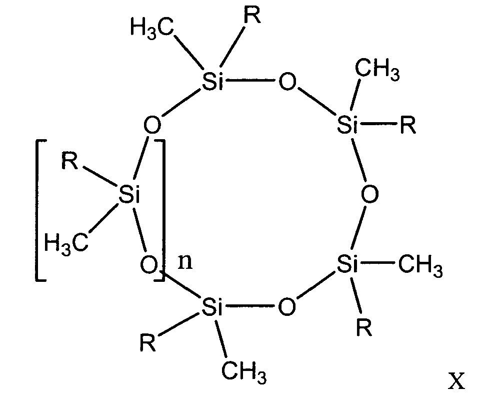 with;
b. a vinyl siloxane oligomer of formula XI 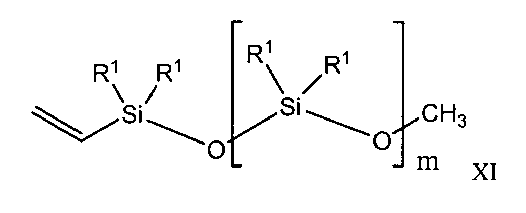 ;and
c. a filler in the presence of a noble metal hydrosilation catalyst.
The polymeric composition has a refractive index from 1.3 to 2.5.

A third aspect of the present invention relates to a prepolymer mixture comprising:
a) a cyclosiloxane oligomer of the formula X: 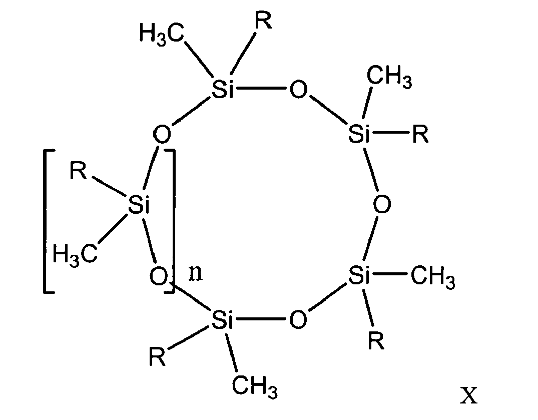 ; and
b) a vinyl siloxane oligomer of the formula XI:

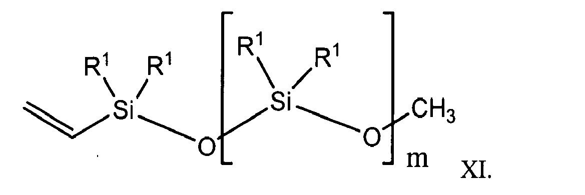

A fourth aspect of the present invention relates to a light emitting device comprising:
a substrate;
a light emitting diode (LED), said LED operably integrated with said substrate; and
a polymeric composition encapsulating said LED, said polymeric composition comprising a polymer produced by the process of reacting:
   a) a cyclosiloxane oligomer of the formula X: 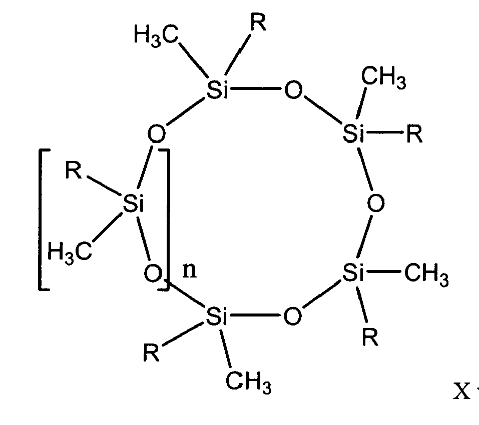 with
   b. a vinyl siloxane oligomer of formula XI

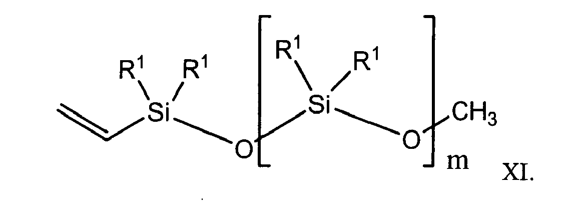

A fifth aspect of the present invention relates to a method for producing a polymer encapsulated light emitting diode comprising: providing a vinyl siloxane oligomer with a viscosity of from 10 to 10,000 cp at 25° C having a plurality of vinyl functionalities; providing a noble metal hydrosilation catalyst; and providing a cyclosiloxane oligomer selected from structure I, structure II, structure III, structure IV, structure V, structure VI, and structure VII: 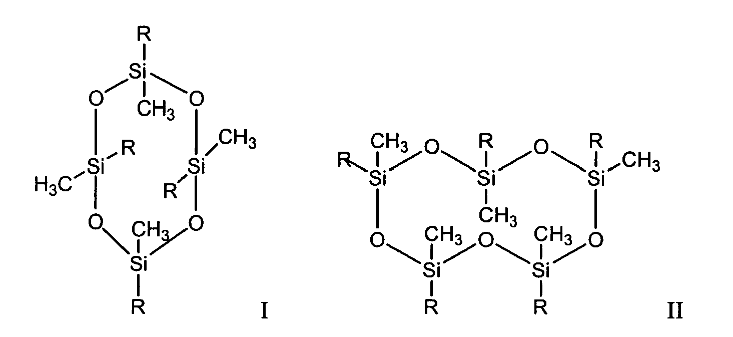 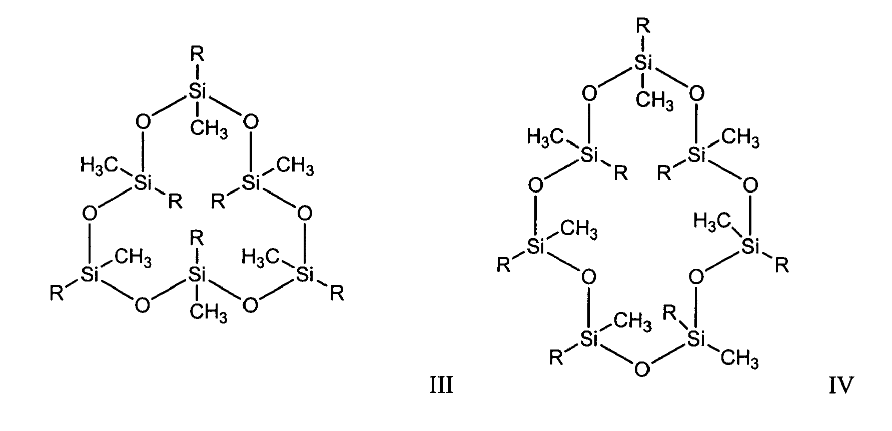 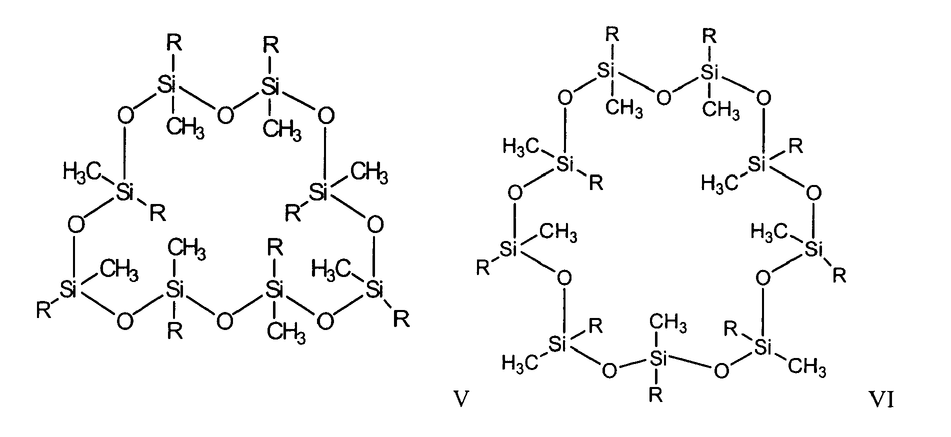 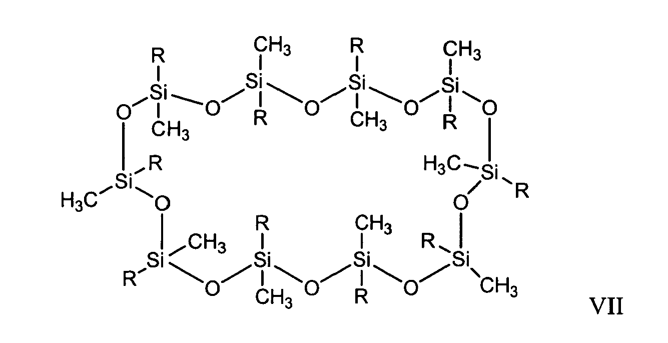 ; combining said vinyl siloxane oligomer, said noble metal hydrosilation catalyst, and said cyclosiloxane oligomer to give a mixture; applying said mixture to a light emitting diode (LED); and curing said mixture to form a polymer encapsulated LED.

A sixth aspect of the present invention relates to a method for producing a polymer encapsulated light emitting diode (LED) comprising:
providing the prepolymer mixture as described above; applying said prepolymer mixture to a LED; and curing said prepolymer mixture to form a polymer encapsulated LED.

### DETAILED DESCRIPTION OF THE INVENTION

Throughout this specification the terms and substituents are defined when first introduced and retain their definitions.

A polymer produced by the process of reacting a cyclosiloxane oligomer and a vinyl siloxane oligomer in the presence of a noble metal hydrosilation catalyst is presented in accordance with the present invention. The cyclosiloxane oligomer is represented by the formula X.

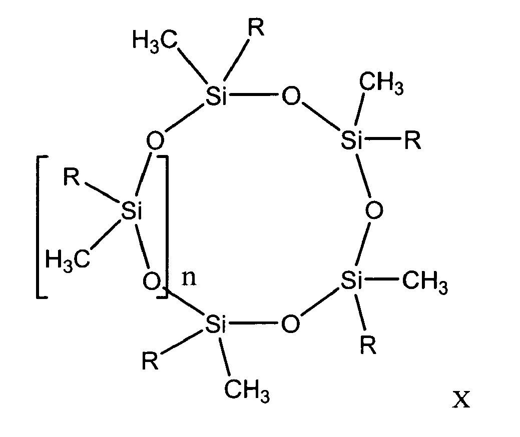

The variable n is an integer from 0 to 6. The substituent R in each occurrence can be chosen independently from hydrogen, a methyl, alkyl, haloalkyl, with the proviso that at least two of R must be H. The variable n also may vary in ranges from a lower limit of 0, 1, 2, or 3 to an upper limit of 4, 5, or 6. All ranges of the variable n are inclusive and combinable. The cyclosiloxane oligomers that may be used in an embodiment of the present invention include, for example, but are not limited to the structures I, II, III, IV, V, VI, and VII: 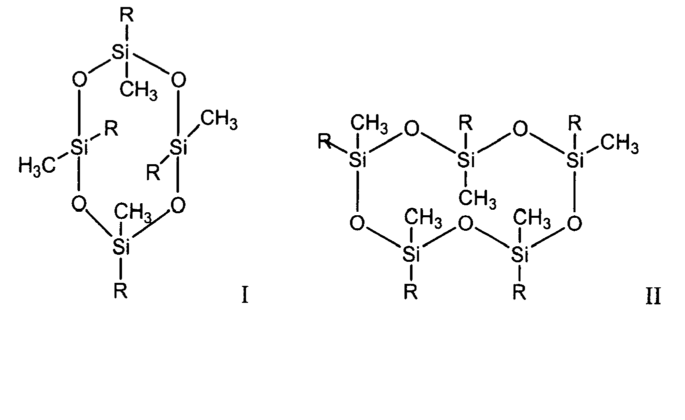 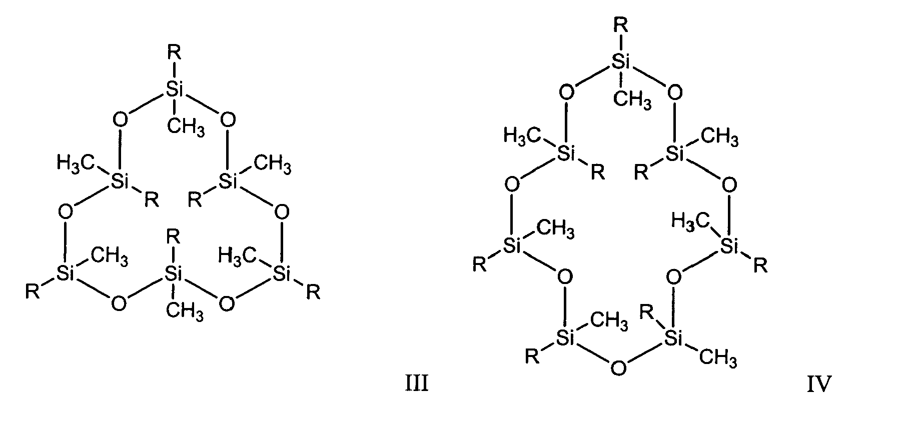 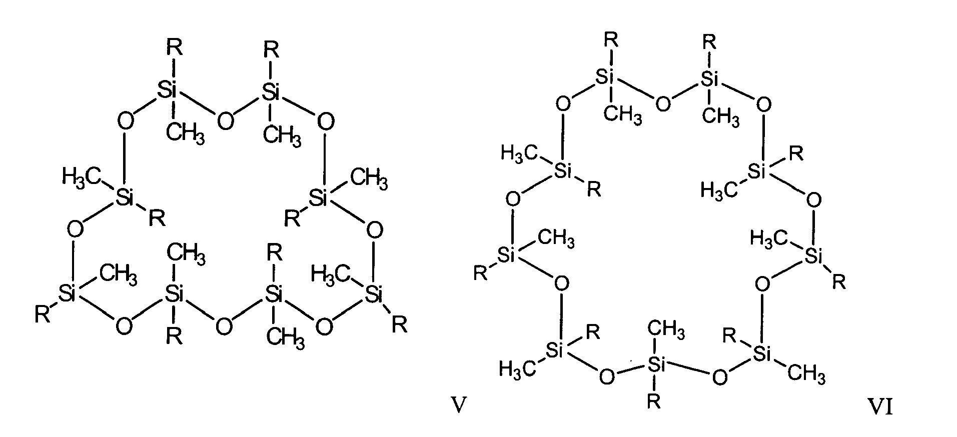 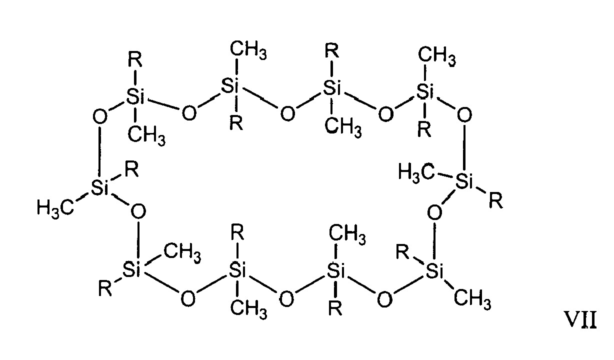 No stereochemistry or geometrical isomerism is implied in the structures shown above. A pure isomer or a mixture of isomers of the compounds I-VII can be employed.

The vinyl siloxane oligomer is represented by formula XI.

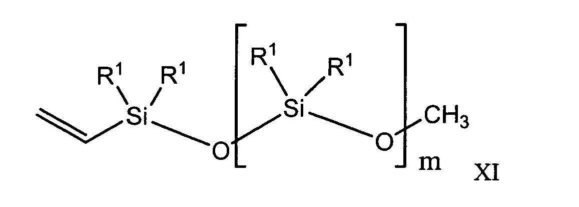

The variable m is an integer from 2 to 20, and the substituent R¹ in each occurrence is chosen independently for each siloxane unit from the group consisting of CH₃, OCH₃, OCH₂CH₃, a vinyl group, and a further unit of [-O-SiR¹₂-]q-OCH₃, with the provisos: that at least one of R¹ must be a vinyl-containing unit; the vinyl siloxane oligomer has a viscosity from 10 centipoise (cp) to 10,000 cp at 25° C; and the ratio of alkoxy groups to Si atoms is in a range from 0.04:1 to 1.5:1.

The subscript q is an integer from 2 to 20. The variable m and the subscript q also may vary in ranges from a lower limit of 2, 3, 4, or 5 to an upper limit of 10, 15, 17, 18, or 20. All of the aforementioned ranges for m and q are inclusive and combinable. The vinyl siloxane oligomer may further vary in viscosity from ranges of: 10-10,000 cp; 20-1,000 cp; 50-600 cp; and 150-500 cp. All of the viscosity ranges are inclusive and combinable. The ratio of alkoxy groups to Si atoms in the vinyl siloxane oligomer may further vary from ranges of: 0.004:1 to 1.5:1; 0.02:1 to 1.3:1; 0.1:1 to 1.2:1; and 0.5:1 to 0.7:1.

The polymer is prepared by the polymerization of the vinyl siloxane oligomer with a Si-H containing cyclosiloxane oligomer in the presence of a noble metal hydrosilation catalyst, as sketched in Scheme 1. The vinyl siloxane oligomer reactant in Scheme 1 is intended to be illustrative rather than definitive of the structure of the vinyl siloxane oligomer.

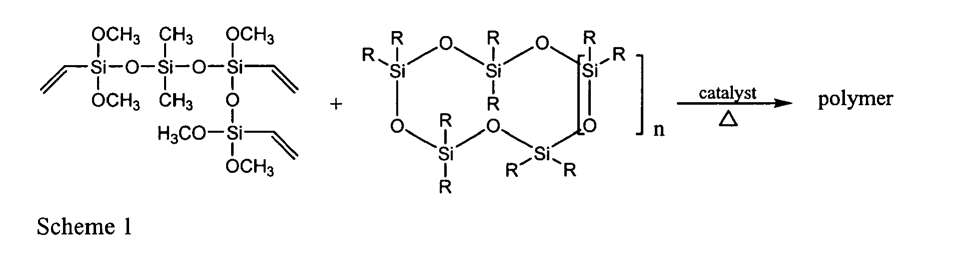

The polymer of the present invention has a refractive index in a range from 1.39 to 1.5. When the polymer is being used to encapsulate, for example, an LED, the artisan will generally attempt to match the R.I. of the cured polymer to the RI of the LED. Refractive indices from 1.3 to 1.5 are the normal range for the polymer, with indices from 1.39 to 1.45 and 1.39 to 1.41 being common. All of the aforementioned ranges are inclusive and combinable. The films also typically exhibit less than a 10 % decrease in light transmission within the range of 450 - 470 nm when the films are exposed to a temperature of 140° C for 1,000 hrs. The exposures were conducted in a forced air oven.

The vinyl siloxane oligomer is assembled by the condensation of a vinyl trialkoxysilane with a dialkyldialkoxysilane in the presence of water, Scheme 2. The molar ratio of the vinyl trialkoxysilane to the dialkyldialkoxysilane ranges from 2.0:1 to1:20; 1.5:1 to 1:10; and 1.1:1.0 to 1:5. All ranges are inclusive and combinable. The result of the condensation reaction is a colorless, transparent, low molecular weight siloxane oligomer having a plurality of vinyl functional groups, i.e. the vinyl siloxane oligomer. The amount of water present in the condensation reaction affects the degree of condensation that occurs. Thus the molecular weight of the vinyl siloxane oligomer is affected by amount of water present.

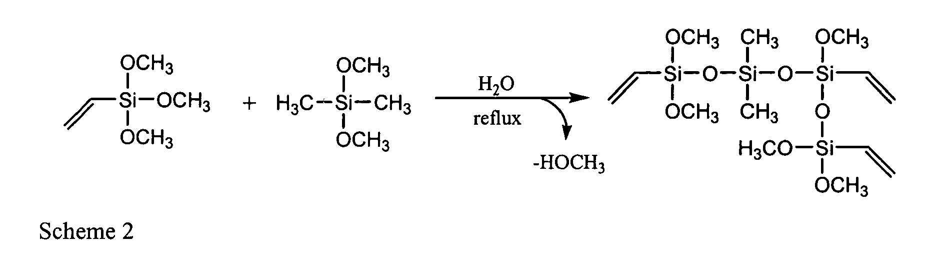

The condensation reaction product depicted in Scheme 2 is intended to be illustrative rather than definitive of the structure of the vinyl siloxane oligomer. It is recognized that the vinyl siloxane oligomer prepared by the above described sol-gel reaction, in fact, may consist of linear repeating units, branched repeating units, cyclic repeating units, and combinations thereof.

Condensation of the starting siloxane materials can be accomplished with or without the use of a condensation catalyst. Acidic or basic condensation catalysts may be employed to increase the rate of the condensation reaction. Acidic condensation catalysts that can be used include, for example, hydrochloric acid, acetic acid, oxalic acid, perchloric acid, p-toluenesulfonic acid, methanesulfonic acid, trifluoromethanesulfonic acid, phosphoric acid, and sulfuric acid. Basic condensation catalysts that can be used include, for example, tetramethylammonium hydroxide, tetraethylammonium hydroxide, guanidine, 4-dimethylaminopyridine, 1,7-diazbicyclo[4.3.0.]nonane, and 1,4-diazabicyclooctane. The condensation reaction can be further accelerated by removal of the alcohol byproduct under reduced pressure.

The reactants in Scheme 2 also may incorporate other siloxane-containing components such as tetramethoxysilane, tetraethoxysilane, methyl trimethoxysilane, ethyltrimethoxysilane, dimethoxydivinylsilane, methylethyldimethoxysilane, diethoxydimethoxysilane, and the like.

In addition to formula XI presented *supra,* the vinyl siloxane oligomer also can be represented by a general compositional formula XII in an embodiment of the present invention.

R^{S}ₙSiO_{(4-n)/2} (XII)

The formula XII is a ratio of R^{S} to Si (silicon atoms) to O (oxygen atoms) wherein R^{S} represents collectively all the alkoxy, methyl, and vinyl substituents R¹, and terminal alkoxy groups of formula XI described *supra* plus 1 vinyl. Examples of R¹ include OCH₃, OCH₂CH₃, methyl, and a vinyl. The variable n may vary in ranges from a lower limit of 1.4, 1.7, 2.0, or 2.1 to an upper limit of 2.3, 2.5, 2.6, or 2.7. The ratio of alkoxy substituents to Si atoms in the vinyl siloxane oligomer is determined using proton Nuclear Magnetic Resonance spectroscopy.

In the hydrosilation-polymerization reaction of the present invention, the equivalent ratio (i.e., equivalents of vinyl to equivalents of Si-H) of the vinyl groups of the vinyl siloxane oligomer to Si-H groups of the cyclosiloxane oligomer range from: 0.5:1.0 to 2.0:1.0; 0.8:1.0 to 1.2:1.0; and 0.9:1.0 to 1.1:1.0. All of the ranges are inclusive and combinable. The description thus far, of a polymer produced by the process of reacting a cyclosiloxane oligomer and a vinyl siloxane oligomer in the presence of a noble metal hydrosilation catalyst, is not meant to imply that the functionalities of the vinyl siloxane oligomer and the cyclosiloxane oligomer react stoichiometrically.

The reaction between the cyclosiloxane oligomer and the vinyl siloxane oligomer is conducted in the presence of a noble metal hydrosilation catalyst. The term noble metal hydrosilation catalyst is meant to encompass compounds and complexes that contain at least one noble metal in which the compound or complex functions a catalyst for hydrosilation of double bonds. The term also encompasses elemental noble metals.

Although rhodium is not always included as a noble metal, in the context of the present invention, Rh compounds, complexes, and the elemental Rh will be referred to as a noble metal herein unless stated otherwise and considered to fall within the definition of the term noble metal, which includes Pd, Pt, Ir and Rh.

In an embodiment of the present invention, a noble metal hydrosilation catalyst for use in the reaction of the cyclosiloxane oligomer with the vinyl siloxane oligomer may include but is not limited to chloroplatinic acid, Karstedt's catalyst (Pt₂{[(CH₂=CH)Me₂Si]₂O}₃), Ashby's catalyst {[(CH₂=CH)MeSiO]₄}₃Pt, Wilkinson's catalyst [tris(triphenylphosphine)rhodium (I) chloride], polymer bound Wilkinson's catalyst, tris(triphenylphosphine)iridium (I) chloride, chloroplatinic acid/octanol complex, platinum cyclovinylmethylsiloxane complex (Ashby-Karstedt Catalyst), platinum carbonyl cyclovinylmethylsiloxane complex, bis(benzonitrile)dichlorpalladium (II), tetrakis(triphenylphosphine)palladium (0), palladium 2,4-pentanedionate, iridium 2,4-pentanedionate, iridium cyclooctadiene chloride, Pt metal, Pd metal, Ir metal, and Rh metal.

Karstedt's catalyst typically is used with the cyclosiloxane oligomer and the vinyl siloxane oligomer described *supra* under reaction conditions that can vary in temperature and time. The reaction can be carried out at a temperature range from 50° C to 200° C. The reaction also can be carried out at temperature ranges varying from: 60° C to 180°C; 70°C to 150° C; and 90° to 120° C. All of the temperature ranges are inclusive and combinable.

The noble metal hydrosilation catalysts are highly efficient and typically only require amounts in parts per million (ppm) for polymerization to occur. In an embodiment of the present of invention, from 1-100 ppm of noble metal hydrosilation catalyst may be present to promote the polymerization of the vinyl siloxane oligomer and the cyclosiloxane oligomer. The range of the amount of noble metal hydrosilation catalyst that may further be present can vary from: 5-80 ppm, 10-60 ppm, and 20-40 ppm. All ranges of the noble metal hydrosilation catalyst are inclusive and combinable.

In choosing the amount of the noble metal hydrosilation catalyst, the artisan will recognize that any amount of noble metal hydrosilation catalyst within the ranges described *supra*, inclusive and/or combined, can be used in which polymerization of the vinyl siloxane oligomer and the cyclosiloxane oligomer is promoted, and in which discoloration of the polymer product due to the residual catalyst does not occur.

The aforementioned temperature ranges are not meant to limit the temperature or temperature range in which the reaction can be carried. The artisan will recognize that any temperature can be used at which hydrosilation is promoted and can occur without degradation to the reactants as well as the polymer product in accordance with the present invention.

Additionally, the temperature ranges are not meant to imply that the hydrosilation reactions must be carried out at a constant temperature. The reaction temperature may be ramped or staged within the temperature ranges described *supra*, inclusive and/or combined, in any manner that allows for the formation of the polymers in accordance with the present invention. For example, a reaction may be carried out a temperature of 50° C for a period of time, for sake of example, 5hrs. After 5 hrs, the temperature may be increased (ramped up) to 100° C and held constant for 2 hrs. The temperature could be continually ramped up until the reaction is complete. The temperature stages and time periods are at the discretion of the practitioner and would be recognized by one ordinarily skilled in the art of polymer chemistry.

The reaction can be carried out over a period of varying times. Typically, the reaction is carried out at a time of 16-20 hrs. However, the artisan will recognize that as the temperature varies the time can be adjusted accordingly for polymerization to occur and polymers of the present invention to be formed. The formation of the product can be monitored via standard spectroscopic instruments and the reaction halted accordingly at a point when the reactants are converted to the polymer product.

A polymeric composition is presented in accordance with the present invention. The polymeric composition comprises the polymer described *supra* and a filler dispersed therein, Scheme 3.

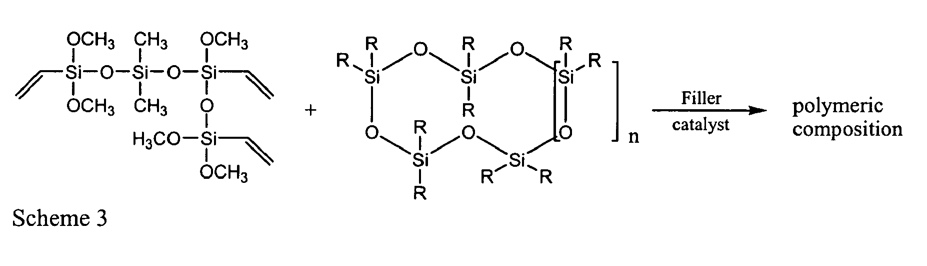

The fillers that may be used in an embodiment of the present invention include but are not limited to colorless oxides of boron, zinc, strontium, silicon, titanium, aluminum, germanium, and tin. The mean particle sizes (*i.e.,* mean diameter of particles) of the aforementioned fillers are in ranges from 0.1 to 10 microns; 0.2 to 5 microns; and 0.5 to 1.0 microns. Other fillers that may be used include carbon nanotubes, solid or hollow glass spheres or quartz fibers, and mica platelets.

Typically, the filler is added to modify the polymeric composition with respect to its overall refractive index and mechanical properties such as shrinkage characteristics, the coefficient of thermal expansion (CTE), and hardness. The filler can comprise the polymeric composition in ranges from: 5 wt % to 60 wt %, 10 wt % to 50 wt %, and 20 wt % to 40 wt%. All of the aforementioned ranges are inclusive and combinable.

The polymeric compositions of the present invention have a refractive index (R.I.) in a range from 1.3 to 2.5. When the compositions are being used to encapsulate, for example, an LED, the artisan will generally attempt to match the R.I. of the cured polymeric composition to the R.I. of the LED. Refractive indices from 1.3 to 2.5 are the normal range with indices from 1.3 to 2.5 and 1.5 to 2.0 being common. The films also typically exhibit less than a 10 % decrease in light transmission within the range of 450 - 470 nm when the films are exposed to a temperature of 140° C for 1,000 hrs. Samples for testing were placed in a forced air oven and removed periodically during two weeks for visual examination. Samples that displayed a perceptible yellow color when held against a white background were considered to have failed the test.

In addition to the filler, the polymeric composition may further contain additives. Examples include but are not limited to phosphors, flow control agents, flatting agents, wetting agents, and adhesion promoters. For example, phosphors may be incorporated to generate specific wavelengths of the emitted light. Flow control, flatting agents, and wetting agents may be employed to facilitate the handling characteristics of the polymeric composition. Polymerization inhibitors and retarders may also be included to control the gel time and to enhance the handling characteristics of the polymeric composition.

Noble metal hydrosilation catalysts that may be used to promote the polymerization of the vinyl oligomer and the cyclosiloxane oligomer have been described *supra*.

Many variables can be manipulated in Scheme 2 to tailor the final mechanical characteristics of the polymeric composition described in Scheme 3 to desired characteristics. For example, the molar ratio of the two reactants in Scheme 2 can be varied resulting in the vinyl siloxane oligomer having a lower or a higher number of vinyl groups present as well as increased or decreased viscosity values. Viscosities of the resin components typically range from 60-500 cps. When compounded with fillers, the viscosities may range from 100-10,000 cps. The viscosity obtained depends on the type and amount of filler added and the particle size of the filler. Viscosity, as described herein, is measured according using a cone on plate viscometer.

Further, metal-containing coreactants in Scheme 2 such as aluminum trimethoxide, titanium tetraethoxide, tetramethoxygermanium, tetraethoxygermanium, zirconium tetramethoxide, tin tetraethoxide, tetraisopropoxy aluminum, and the like can be used to modify the refractive index of the polymeric composition.

The polymer and polymeric compositions of the present invention may be used as encapsulants and in combination with substrates such as a LED, an optical circuit, a lasing element, an optical component such as an optical coupler, a repeater, a waveguide, and a fiber optic adhesive.

A light emitting device comprising a substrate, a light emitting diode (LED), and a polymeric composition encapsulating the LED is presented in accordance with the present invention. In one embodiment of the present invention, the substrate may be, for example, a circuit board, a metallic cup, a ceramic cup, a metallic reflector, and like. Additionally the substrate may have reflective properties. The LED is integrated with the substrate via an electronic circuit to allow normal operation of the LED. In addition, the encapsulant may serve as an in-situ lens for the LED.

The LED used in an embodiment of the present invention is a semiconductor device that emits visible light when an electric current passes through it. The light is typically emitted in a narrow wavelength band. The output range is from red (at a wavelength of approximately 700 nanometers) to blue-violet (about 400 nanometers). The LED may emit infrared energy (830 nanometers or longer) if chosen to do so and such a device is typically known as an infrared-emitting diode (IRED). At the same time, LEDs operating in the UV (200-400 nm) are currently being developed. The polymeric composition (encapsulant) used to encapsulate the LED is as described *supra.*

The light emitting device of the present invention operates under severe environmental conditions ranging from 1,000 hrs to about 100,000 hrs at a temperature in a range from 100° C to 250° C. Typical operating conditions include a time period from 1,000 hrs to 40,000 hrs at a temperature in a range from 100° C to 200° C. A test to ascertain the sufficiency of the polymeric composition for its intended purpose is to thermally age the cured polymeric composition at 150-200° C in air depending on the specific application. Aging can also be conducted in the presence of light of a wavelength emitted by the LED. Polymeric compositions of the present invention exhibit high resistance to yellowing, erosion, and loss of mechanical properties under the above thermal oxidative conditions.

A method for producing a polymer encapsulated LED is presented in accordance with the present invention. The method comprises providing a vinyl siloxane oligomer; providing a noble metal hydrosilation catalyst; providing a cyclosiloxane oligomer; combining the vinyl siloxane oligomer, the noble metal hydrosilation catalyst, and the cyclosiloxane oligomer to give a mixture; applying the mixture to a light emitting diode (LED; and curing the mixture to form a polymer encapsulated LED.

The vinyl siloxane oligomer used for producing a polymer encapsulated LED contains a plurality of vinyl functional groups and is as described *supra,* as is the noble metal hydrosilation catalyst, and the cyclosiloxane oligomer. The vinyl siloxane oligomer, the noble metal hydrosilation catalyst, and the cyclosiloxane oligomer are combined to form a mixture. All are well-known in the art. The mixture additionally may comprise a filler material.

The aforementioned components can be combined in any order. Typically the vinyl siloxane oligomer, the filler material, and the noble metal hydrosilation catalyst are combined first. Then the cyclosiloxane oligomer is added. Heat may be added at any point during the combination step to provide a low viscosity mixture. The mixture is applied to a LED and subsequently cured. The LED may be an individual LED or an array of LEDs. Oven curing, infrared curing, hotplate curing, heated mold curing, and combinations thereof may be used to accomplish curing of the mixture.

A prepolymer mixture comprising a cyclosiloxane oligomer and a vinyl siloxane oligomer is presented in accordance with the present invention.
The cyclosiloxane oligomer is represented by the formula X: 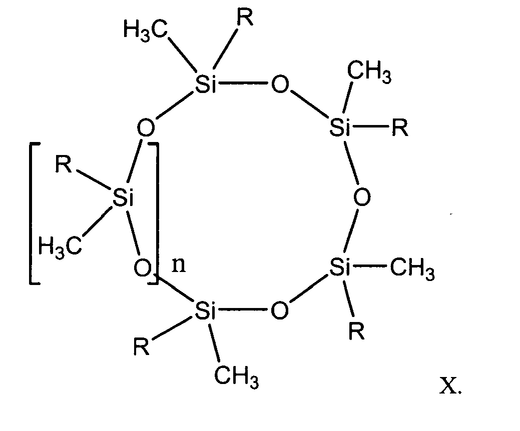 The vinyl siloxane oligomer is represented by the formula XI:

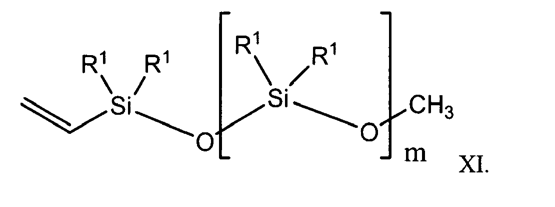

The mixture may additionally comprise a noble metal hydrosilation catalyst and/or a filler as well as other additives. The prepolymer mixture may further comprise additional components that together constitute less than 10 % by weight of the prepolymer mixture.

An alternative method for producing a polymer encapsulated light emitting diode (LED) comprises: providing a prepolymer mixture; applying the prepolymer mixture to a LED, and curing the prepolymer mixture to form a polymer encapsulated LED. The prepolymer mixture provided is as described *supra.*

The prepolymer mixture may be heated to a temperature such that the viscosity of the mixture allows for manipulation and application to an individual LED or an array of LEDs. However, the prepolymer mixture does not have to be heated. The prepolymer mixture can be applied as received if the mixture has a viscosity suitable for application to the LED array. The mixture is applied to a LED and subsequently cured. Oven curing, infrared curing, hotplate curing, heated mold curing, and combinations thereof may be used to accomplish curing of the mixture.

The aforementioned curing techniques are not meant to limit the types or kinds of curing techniques that may be used to cure the prepolymer mixture in an embodiment of the present invention. The artisan will recognize that any curing technique, which causes hydrosilation-polymerization of the prepolymer mixture components, i.e., the cyclosiloxane oligomer and the vinyl siloxane oligomer, can be used as a curing technique in accordance with the present invention.

### EXPERIMENTAL

Testing Methods
1. Viscosities of the unfilled encapsulant were measured using Ford Cup viscometer.
2. Cone on plate viscosities of both filled and unfilled encapsulant mixtures were measured using a Brookfield CP-52 cone and plate viscometer. Alternatively, a Brookfield Spindle-type viscometer was also used, especially in the case of more viscous mixtures.
3. Nuclear Magnetic Resonance (NMR) spectroscopic method to determine alkoxy functionality to Si atom ratio
The ratios of alkoxy/Si discussed *supra* are determined as follows:

Known weights (measured to four decimal places) of both the vinyl siloxane oligomer and dry toluene are dissolved in deuterated chloroform to give a deuterated chloroform solution. The integrated methoxy proton peak of the vinyl siloxane oligomer and the integrated methyl proton peak of toluene are measured by H' NMR, using a Bruker AMX-500 MHz NMR spectrometer.

The methoxy proton signal occurs at a chemical shift = -1.0 ppm relative to the methyl proton signal of toluene; although tetramethyl silane is not used as a standard due to interference with methyl protons directly bound to silicon atoms of the vinyl siloxane oligomer, it is well known that the chemical shift of the methyl signal of toluene occurs at 3.5 ppm relative to tetramethyl silane; therefore it is calculated that the chemical shift of the methoxy groups of the vinyl siloxane oligomer would be 2.5 ppm relative to tetramethyl silane.

The number of equivalents of methoxy groups of the vinyl siloxane oligomer relative to the number of equivalents of toluene methyl groups is then calculated. The number of equivalents of vinyl groups of the vinyl siloxane oligomer relative to the methyl groups of the toluene is already known because the vinyl groups are unchanged by the condensation reaction that forms the vinyl siloxane oligomer, and the weight ratios of the vinyl siloxane oligomer to toluene are known.

The number of equivalents of silicon atoms in the vinyl siloxane oligomer relative to the methyl groups of the toluene is also known because the number of silicon atoms is also unchanged by the reaction, which produces the vinyl siloxane oligomer. The ratio of equivalents of methoxy groups to equivalents of vinyl groups, and of equivalents of methoxy groups to equivalents of silicon atoms is therefore calculated by this test method.

When ethoxy groups are present as substituents of the vinyl siloxane oligomer, the ethoxy groups can be similarly quantified by integrating the area under the peaks for the methylene protons, or the methyl protons of the ethoxy group.

According to this method, the vinyl oligomer of example 1 exhibited a ratio of alkoxy/Si of 0.004/1.

### EXAMPLES

### Example 1:

Vinyltrimethoxysilane (20.7 g, 0.14 mol) and dimethyldimethoxysilane (33.6 g, 0.28 mol) were placed in a 250 ml round bottom flask. Water (17.6 ml) was added and the solution was brought to reflux for 24 hours at 60° C. The mixture was cooled to room temperature, and two layers were formed. The biphasic mixture was transferred to a separatory funnel. The lower layer was separated and transferred to a 100 ml round bottom flask then dried under vacuum in a rotary evaporator for 3 hours. The flask was removed and attached to an oil pump to remove any residual starting materials and volatile byproducts for 24 hours. A clear colorless liquid was obtained (96% conversion) being the vinyl siloxane oligomer.

The polymerization of the vinyl siloxane oligomer was carried out as follows. The vinyl siloxane oligomer (0.5 g) was mixed with 0.3 microL of Karstedt's catalyst and 0.35 g of UVT Sunspheres (silica, size: 7micrometers). This mixture then was heated in an oven for 45 min at 90° C to de-gas the solution and to decrease the viscosity. While hot, 0.2 g of a cyclosiloxane oligomer, 1,3,5,7,9-pentamethylcyclopentasiloxane (D₅^{H}), was added and the mixture was gently swirled to avoid entrapment of air. The mixture was poured onto a LED array and the device placed in a forced air oven at 90° C for 18 hr. The temperature was slowly ramped down to room temperature over the course of 3 hr. The encapsulated LED was translucent, hard, and crosslinked.

A wide variety of epoxides and other types of thermoset resins were evaluated under simulated high intensity LED operating conditions. The most common failure was due to thermooxidative degradation that results in resins that have undergone pronounced color changes ranging from yellow to deep brown.

The only polymeric materials that survived the aggressive screening test were the polymers and polymeric compositions of the present invention. They have excellent thermal oxidative resistance, and even when polymers and polymeric compositions undergo degradation, the products are generally colorless.

The thermal oxidative stability of the corresponding UV cured resins were examined. Specifically, the epoxy resins containing SOC10 as the photoinitiator were placed in small aluminum cups and then polymerized by exposure to UV light using a medium pressure mercury arc lamp. Table 1 shows the results of visual inspections of the cured formulations after aging for 2 days at 140°C. Samples for testing were placed in a forced air oven and removed periodically during two weeks for visual examination. Samples that displayed a perceptible yellow color when held against a white background were considered to have failed the test.

The structures of some of the resins prior to cure that were employed are depicted below.

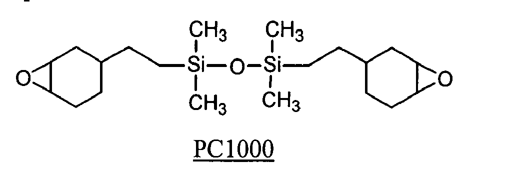

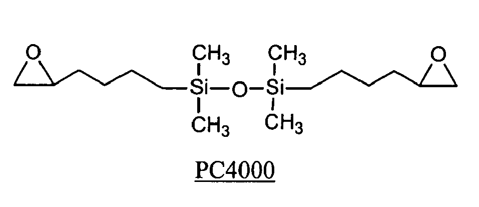

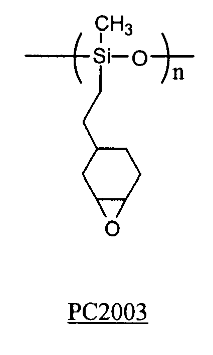

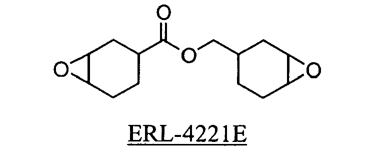

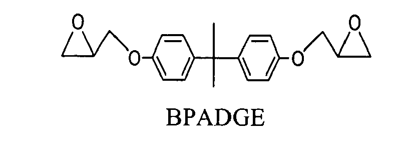

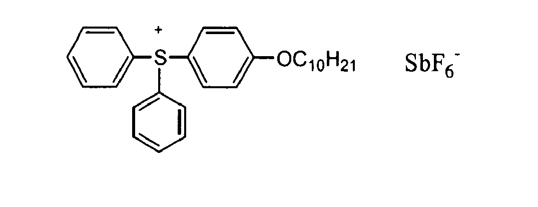

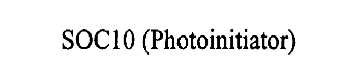

**Table 1 Results of Thermal Aging of UV Cured Epoxy Resins**

| **Monomer** | **SOC10 (mol%)** | **Results** |
|---|---|---|
| ERL-4221E | 1.0 | clear, no color change |
| PC 1000 | 1.0 | clear, slightly yellow |
| PC2003 | 0.5 | clear, slightly yellow |
| PC1000/ Cop BMA/MMA* | 2.0 | hazy, very slightly yellow |
| PC1000/ PVB^{#} | 1.0 | yellow |
| PC 1000 | 1.5 | clear, slightly yellow |
| BPADGE | 2.0 | Very yellow |
| SF-96 Silicone fluid | - | clear, colorless |
| Polymeric compositions of present invention (Exp #1) | - | clear, colorless |

| | | |
|---|---|---|
| * 17 % by weight of copolymer of butylmethacrylate and methyl methacrylate #17% by weight of polyvinyl butyral. | | |

After 10 days of thermal oxidative aging at 140° C, all the samples were noticeably yellow. The resins that displayed the best performance to date were ERL-4221 E and PC 1000. Although ERL-4221 E shows good initial resistance towards yellowing, after 4 days its degree of yellowing as approximately the same as the other resins. Formulations containing added linear acrylic polymers (copolymer BMA/MMA or polyvinyl butyral appear to undergo phase separation on thermal aging and to give hazy, phase-separated samples.

Several polydimethylsiloxane (silicone) resins (e.g. SF-96 silicone fluid) were evaluated in the above-described screening tests. The results were dramatic. Even after 4 weeks (672 hours) at 140 °C in air, there was no observable yellowing.

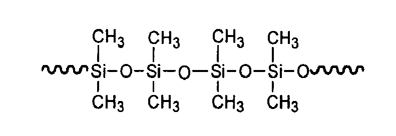

Polydimethylsiloxanes with the structure shown above have excellent inherent thermal oxidative stability. However, on long term exposure to heat, even these resins do undergo slow degradative bond cleavage reactions. Apparently, the key to the ability of these resins to survive the screening test is due to the fact that despite this degradation, the products that are produced are not colored.

## Claims

1. A polymer produced by the process of reacting:
1. a cyclosiloxane oligomer of the formula X: 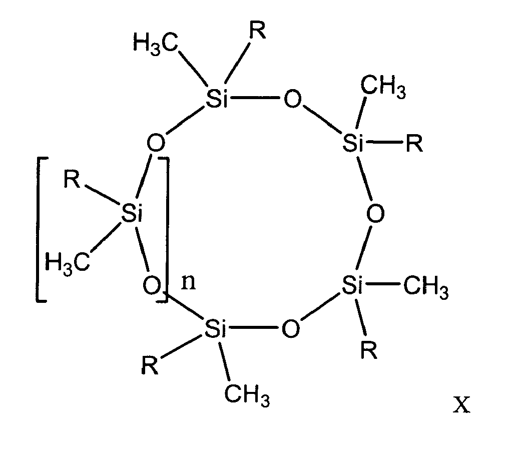 wherein n is an integer from 0 to 6;
R in each occurrence is chosen independently from H, a methyl, an alkyl, and a haloalkyl, with the proviso that at least two of R must be H, with
2. a vinyl siloxane oligomer of formula XI 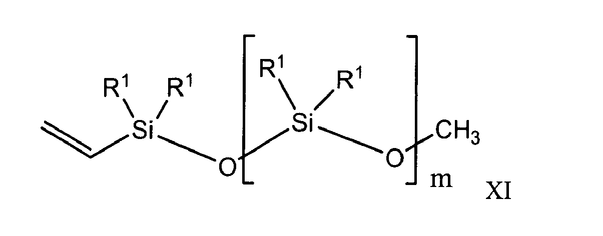 wherein m is an integer from 2 to 20;
R¹ in each occurrence is chosen independently for each siloxane unit from CH₃, OCH₃, OCH₂CH₃, vinyl, and a further unit of [-O-SiR¹₂-]q-OCH₃, wherein q is an integer from 2 to 20;
in the presence of a noble metal hydrosilation catalyst,
with the provisos that at least one of R¹ must be a vinyl containing unit, said vinyl siloxane oligomer has a viscosity from 10 centipoise to 10,000 centipoise at 25° C, and the ratio of alkoxy groups to Si atoms is in a range from 0.004:1 to 1.5:1.

2. A polymer according to claim 1, wherein said noble metal hydrosilation catalyst is selected from the group consisting of chloroplatinic acid, Karstedt's catalyst (Pt₂{[(CH₂=CH)Me₂Si]₂O}₃), Ashby's catalyst {[(CH₂=CH)MeSiO]₄}₃Pt, Wilkinson's catalyst [tris(triphenylphosphine)rhodium (I) chloride], polymer bound Wilkinson's catalyst, [tris(triphenylphosphine)iridium (I) chloride], chloroplatinic acid/octanol complex, platinum cyclovinylmethylsiloxane complex (Ashby-Karstedt Catalyst), platinum carbonyl cyclovinylmethylsiloxane complex, bis(benzonitrile)dichlorpalladium (II), tetrakis(triphenylphosphine)palladium (0), palladium 2,4-pentanedionate, iridium 2,4-pentanedionate, iridium cyclooctadiene chloride, Pt metal, Pd metal, Rh metal, Ir metal, and combinations thereof.

3. A polymer according to claim 1 or claim 2, produced by a process wherein said cyclosiloxane oligomer reacts with said vinyl siloxane oligomer in the presence of Pt₂{[(CH₂=CH)Me₂Si]₂O}₃ at a temperature from 50° C to 200° C.

4. A polymer according to any one of the preceding claims, wherein n is 1.

5. A polymeric composition produced by the process of reacting:
a. a cyclosiloxane oligomer of the formula X: 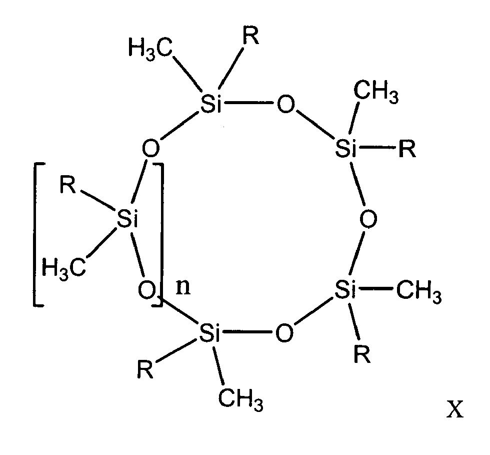 wherein n is an integer from 0 to 6;
R in each occurrence is chosen independently from H, a methyl, an alkyl, and a haloalkyl, with the proviso that at least two of R must be H, with
b. a vinyl siloxane oligomer of formula XI 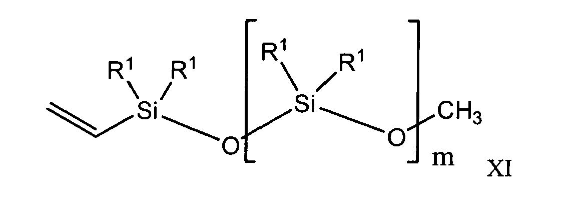 wherein m is an integer from 2 to 20;
R¹ in each occurrence is chosen independently for each siloxane unit from CH₃, OCH₃, OCH₂CH₃, vinyl, and a further unit of [-O-SiR¹₂-]q-OCH₃, wherein q is an integer from 2 to 20;
in the presence of a noble metal hydrosilation catalyst,
with the provisos that at least one of R¹ must be a vinyl containing unit, said vinyl siloxane oligomer has a viscosity from 10 centipoise to 10,000 centipoise at 25°C, and the ratio of alkoxy groups to Si atoms is in a range from 0.004:1 to 1.5:1; and
c. a filler,
in the presence of a noble metal hydrosilation catalyst, said polymeric composition having a refractive index from 1.3 to 2.5

6. A polymeric composition according to claim 5, wherein said filler is chosen from oxides of boron, silicon, titanium, aluminum, germanium, tin, strontium, and zinc having mean particle sizes in a range from 0.1 to 10.0 microns.

7. A polymeric composition according to claim 5 or claim 6, wherein said filler comprises from 5 wt % to 60 wt % of said polymeric composition.

8. A polymeric composition according to any one of claims 5 to 7, said polymer exhibiting less than 10 % decrease in light transmission within the range of 450-470 nm when said polymer is exposed to a temperature of 140° C for 1,000 hrs.

9. A polymeric composition according to any one of claims 5 to 8, produced by a process wherein said cyclosiloxane oligomer reacts with said vinyl siloxane oligomer in the presence of Pt₂{[(CH₂=CH)Me₂Si]₂O}₃ at a temperature from 50° C to 200° C.

10. A prepolymer mixture comprising:
a) a cyclosiloxane oligomer of the formula X: 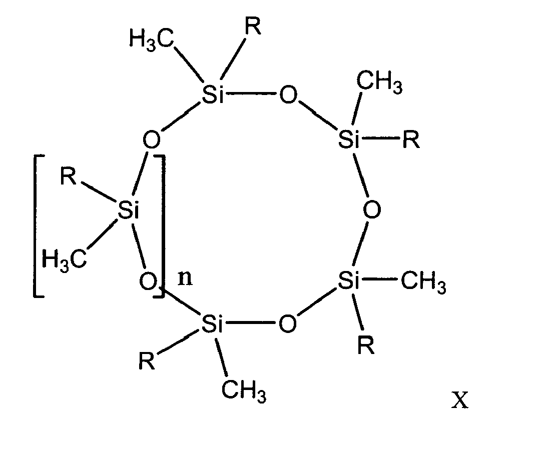 wherein n is an integer from 0 to 6;
R in each occurrence is chosen independently from H, a methyl, an alkyl, and a haloalkyl, with the proviso that at least two of R must be H, and
b) a vinyl siloxane oligomer of the formula XI: 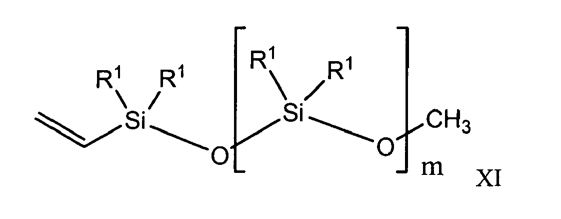 wherein m is an integer from 2 to 20;
R¹ in each occurrence is chosen independently for each siloxane unit from CH₃, OCH₃, OCH₂CH₃, vinyl, and a further unit of [-O-SiR¹₂-]q-OCH₃, wherein q is an integer from 2 to 20;
with the provisos that at least one of R¹ must be a vinyl containing unit, said vinyl siloxane oligomer has a viscosity from 10 centipoise to 10,000 centipoise at 25°C, and the ratio of alkoxy groups to Si atoms is in a range from 0.004:1 to 1.5:1.

11. A prepolymer mixture according to claim 10 additionally comprising a noble metal hydrosilation catalyst.

12. A prepolymer mixture according to claim 10 or claim 11 additionally comprising a filler.

13. A prepolymer mixture according to claim 12, wherein said filler is chosen from oxides of boron, silicon, titanium, aluminum, germanium, tin, strontium, and zinc having mean particle sizes in a range from 0.1 to 10.0 microns.

14. A prepolymer mixture according to claim 12 or claim 13 further comprising additional components wherein said additional components together constitute less than 10% by weight of said prepolymer mixture.

15. A prepolymer mixture according to claim 11, wherein said noble metal hydrosilation catalyst is selected from the group consisting of chloroplatinic acid, Karstedt's catalyst (Pt₂{[(CH₂=CH)Me₂Si]₂O}₃), Ashby's catalyst {[(CH₂=CH)MeSiO]₄}₃Pt, Wilkinson's catalyst [tris(triphenylphosphine)rhodium (I) chloride], polymer bound Wilkinson's catalyst, tris(triphenylphosphine)iridium (I) chloride, chloroplatinic acid/octanol complex, platinum cyclovinylmethylsiloxane complex (Ashby-Karstedt Catalyst), platinum carbonyl cyclovinylmethylsiloxane complex, bis(benzonitrile)dichlorpalladium (II), tetrakis(triphenylphosphine)palladium (0), palladium 2,4-pentanedionate, iridium 2,4-pentanedionate, iridium cyclooctadiene chloride, Pt metal, Pd metal, Rh metal, Ir metal, and combinations thereof.

16. A prepolymer mixture according to claim 11, wherein said noble metal hydrosilation catalyst is Karstedt's catalyst Pt₂{[(CH₂=CH)Me₂Si]₂O}₃.

17. A light emitting device comprising:
a substrate;
a light emitting diode (LED), said LED operably integrated with said substrate; and
a polymeric composition encapsulating said LED, said polymeric composition comprising a polymer produced by the process of reacting:
a) a cyclosiloxane oligomer of the formula X: 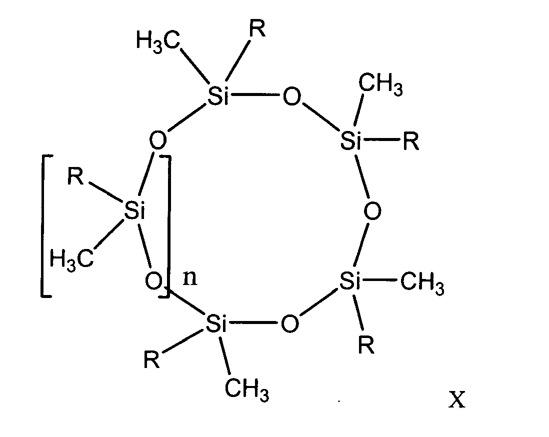 wherein n is an integer from 0 to 6;
R in each occurrence is chosen independently from H, a methyl, an alkyl, and a haloalkyl, with the proviso that at least two of R must be H, with
b) a vinyl siloxane oligomer of formula XI 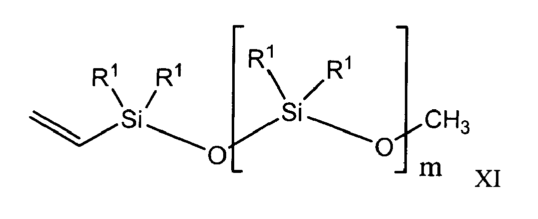 wherein m is an integer from 2 to 20;
R¹ in each occurrence is chosen independently for each siloxane unit from CH₃, OCH₃, OCH₂CH₃, vinyl, and a further unit of [-O-SiR¹₂-]q-OCH₃, wherein q is an integer from 2 to 20;
in the presence of a noble metal hydrosilation catalyst,
with the provisos that at least one of R¹ must be a vinyl containing unit, said vinyl siloxane oligomer has a viscosity from 10 centipoise to 10,000 centipoise at 25°C, and the ratio of alkoxy groups to Si atoms is in a range from 0.004:1 to 1.5:1.

18. A light emitting device according to claim 17, wherein n is 1.

19. A light emitting device according to claim 17 or claim 18, wherein said polymeric composition exhibits less than 10 % decrease in light transmission within the range of 450-470 nm when said polymeric composition is exposed to a temperature of 140° C for 1,000 hrs.

20. A light emitting device according to any one of claims 17 to 19, wherein said polymeric composition additionally comprises a filler.

21. A light emitting device according to any one of claims 17 to 20, wherein said polymeric composition has a refractive index from 1.3 to 2.5.

22. A light emitting device according to claim 20, wherein said filler is chosen from oxides of boron, silicon, titanium, aluminum, germanium, tin, strontium, and zinc having a mean particle size in a range from 0.1 to 10.0 microns.

23. A light emitting device according to claim 20 or claim 22, wherein said filler comprises from 5 wt % to 60 wt % of said polymer.

24. A method for producing a polymer encapsulated light emitting diode (LED) comprising:
providing a vinyl siloxane oligomer having a plurality of vinyl functionalities and a viscosity from 10 centipoise to 10,000 centipoise at 25° C;
providing a noble metal hydrosilation catalyst; and
providing a cyclosiloxane oligomer selected from structure I, structure II, structure III, structure IV, structure V, structure VI, and structure VII: 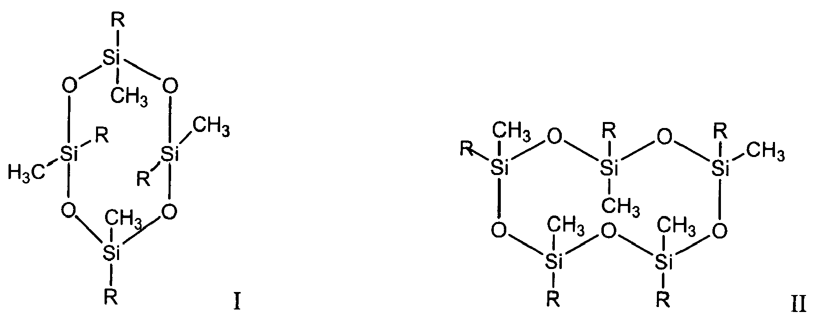 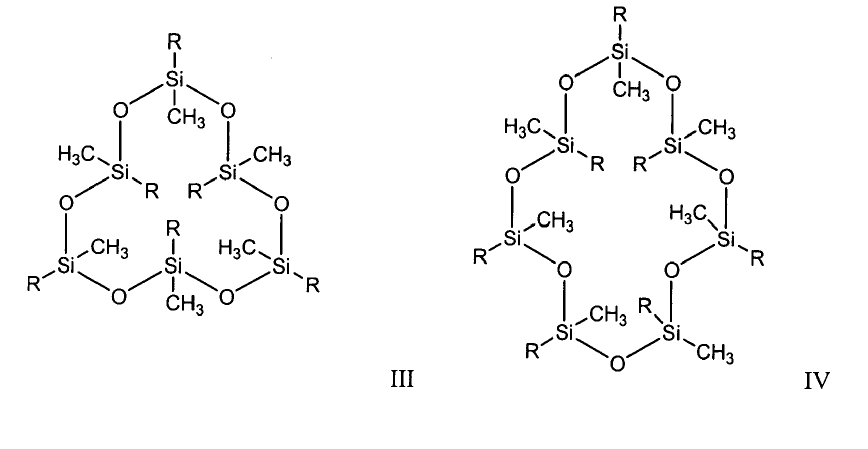 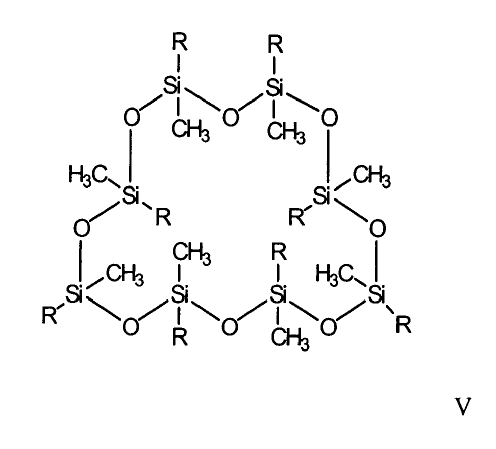 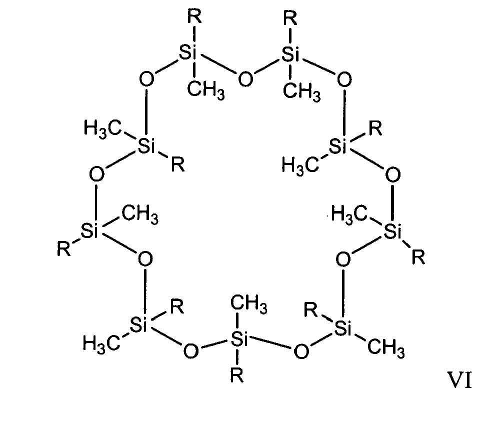 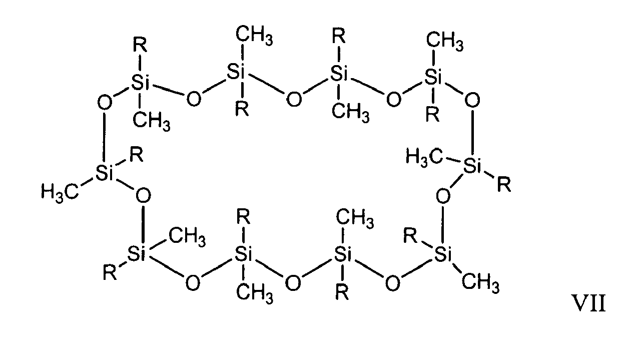
wherein R in each occurrence is chosen independently from H, a methyl, an alkyl, and a haloalkyl, with the proviso that at least two of R must be H;
combining said vinyl siloxane oligomer, said noble metal hydrosilation catalyst, and said cyclosiloxane oligomer to give a mixture;
applying said mixture to a LED; and
curing said mixture to form a polymer encapsulated LED.

25. A method according to claim 24, wherein said curing includes a method selected from the group consisting of oven curing, infrared curing, hotplate curing, heated mold curing, and combinations thereof.

26. A method according to claim 24 or claim 25, wherein said vinyl siloxane oligomer is of formula XI: 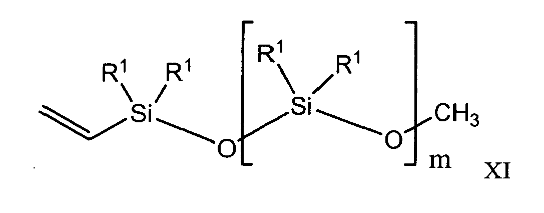 wherein m is an integer from 2 to 20;
R¹ in each occurrence is chosen independently for each siloxane unit from CH₃, OCH₃, OCH₂CH₃, vinyl, and a further unit of [-O-SiR¹₂-]q-OCH₃, wherein q is an integer from 2 to 20;
with the provisos that at least one of R¹ must be a vinyl containing unit and the ratio of alkoxy groups to Si atoms is in a range from 0.004:1 to 1.5:1.

27. A method according to any one of claims 24 to 26, wherein said mixture additionally comprises a filler material.

28. A method for producing a polymer encapsulated light emitting diode (LED) comprising:
providing a prepolymer mixture according to any one of claims 10 to 16, applying said prepolymer mixture to a LED; and
curing said prepolymer mixture to form a polymer encapsulated LED.

29. A method according to claim 28 wherein said curing includes a method selected from the group consisting of oven curing, infrared curing, hotplate curing, heated mold curing, and combinations thereof.
